# EUROPEAN PATENT APPLICATION

(11) **EP 4 750 266 A1**
(43) Date of publication of application: **27.05.2026**
(21) Application number: 24843135.5
(22) Date of filing: 16.07.2024
(51) Int. Cl.: H10F 19/00

(54) **POWER GENERATION MODULE**

(30) Priority: 19.07.2023 JP 2023117878
(71) Applicant: Panasonic Intellectual Property Management Co., Ltd., Kadoma-shi, Osaka 571-0057 (JP)
(72) Inventor: HIRANO, Koichi, Kadoma-shi, Osaka 571-0057 (JP); KANEMATSU, Daiji, Kadoma-shi, Osaka 571-0057 (JP); UCHIDA, Ryusuke, Kadoma-shi, Osaka 571-0057 (JP); HIGUCHI, Hiroshi, Kadoma-shi, Osaka 571-0057 (JP); KATAYAMA, Hirotaka, Kadoma-shi, Osaka 571-8501 (JP)
(74) Representative: Appelt, Christian W.
(86) International application number: PCT/JP2024/025516
(87) International publication number: WO 2025/018345

(57) **Abstract**

A power generation module suppressing breakage of lead wires is provided. The power generation module includes a first substrate, a second substrate having a light-transmitting property, a solar cell located between the first substrate and the second substrate, a sealing member sealing a gap between the first substrate and the second substrate and having an annular shape surrounding the solar cell, and a lead wire connected to the solar cell and passing through the sealing member. The solar cell includes two electrode layers and a semiconductor layer located between the two electrode layers. One of the two electrode layers has a connection connected to the lead wire. The sealing member has a pass-through portion. The lead wire passes through and fixed to the pass-through portion. An internal wiring portion of the lead wire between the connection and the pass-through portion is longer than the shortest distance between the connection and the pass-through portion.

## Description

### TECHNICAL FIELD

The present disclosure relates to a power generation module used in building integrated photovoltaics (BIPV).

### BACKGROUND ART

As for this type of power generation module, the one described in Patent Document 1, for example, is known traditionally. The power generation module described in Patent Document 1 includes a first substrate, a solar cell element disposed on the first substrate, and a second substrate facing the first substrate through the solar cell element. The gap between the edge of the first substrate and the edge of the second substrate is sealed with a sealing member.

The solar cell element has a transparent conductive layer disposed on the first substrate, a semiconductor layer stacked over the transparent conductive layer, and a conductive layer stacked over the semiconductor layer. Lead wires are connected to the conductive layer for extracting the power generated in the solar cell element to the outside of the power generation module. The lead wires pass through the sealing member and are extended to the outside of the power generation module.

### PRIOR ART DOCUMENT

### PATENT DOCUMENT

Patent Document 1: JP7187284B

### SUMMARY OF INVENTION

### TECHNICAL PROBLEM

The power generation module of Patent Document 1 still has room for improvement in terms of suppressing breakage of the lead wires for extracting electric power.

Thus, an object of the present disclosure is to solve the above problem and to provide a power generation module in which breakage of lead wires for extracting electric power is suppressed.

### MEANS FOR SOLVING PROBLEM

A power generation module according to the present disclosure includes: a first substrate; a second substrate having a light-transmitting property, the second substrate facing the first substrate in a thickness direction of the first substrate; a solar cell located between the first substrate and the second substrate; a sealing member sealing a gap between the first substrate and the second substrate, the sealing member having an annular shape surrounding the solar cell in a plan view seen along the thickness direction; and a lead wire connected to the solar cell and passing through the sealing member. The solar cell has a stacked structure, two electrode layers and a semiconductor layer being located between the two electrode layers in the thickness direction are stacked in the stacked structure. One of the two electrode layers has a connection connected to the lead wire. The sealing member has a pass-through portion, the lead wire passing through and being fixed to the pass-through portion. The lead wire has an internal wiring portion between the connection and the pass-through portion. A length of the internal wiring portion is greater than the shortest distance between the connection and the pass-through portion.

### ADVANTAGEOUS EFFECT OF INVENTION

According to the power generation module of the present disclosure, breakage of the lead wires for extracting electric power can be suppressed.

### BRIEF DESCRIPTION OF DRAWINGS

Fig. 1 is a plan view of a power generation module according to a first embodiment of the present disclosure.
Fig. 2 is a cross-sectional view taken along line II-II in Fig. 1.
Fig. 3 is an enlarged cross-sectional view showing an area EA2 in Fig. 2.
Fig. 4 is a cross-sectional view of a lead wire disposed in the power generation module of Fig. 1.
Fig. 5 is a diagram showing a power generation module according to a second embodiment of the present disclosure, and is an enlarged plan view corresponding to an area EA1 in Fig. 1.
Fig. 6 is a diagram showing a power generation module according to a second embodiment of the present disclosure, and is an enlarged cross-sectional view corresponding to the area EA2 in Fig. 2.
Fig. 7 is a plan view of a power generation module according to a third embodiment of the present disclosure.
Fig. 8 is an enlarged plan view corresponding to an area EA3 in Fig. 7.
Fig. 9 is a diagram showing a power generation module according to a third embodiment of the present disclosure, and is an enlarged cross-sectional view corresponding to the area EA2 in Fig. 2.
Fig. 10 is a diagram showing a power generation module according to a fourth embodiment of the present disclosure, and is an enlarged cross-sectional view corresponding to the area EA2 in Fig. 2.
Fig. 11 is a cross-sectional view corresponding to Fig. 2, showing a variant of the power generation module according to the first embodiment of the present disclosure.

### DESCRIPTION OF EMBODIMENTS

### (Findings that Form the Basis of This Disclosure)

In a conventional power generation module, a solar cell element is housed in an internal space of the power generation module defined by a first substrate, a second substrate, and a sealing member. The sealing member is made of, for example, an elastic material to suppress moisture intrusion into the internal space.

The sealing member contracts and expands with changes in the temperature of the environment in which the power generation module is installed. As the sealing member contracts, lead wires passing through the sealing member are pulled in the direction from the solar cell element toward the sealing member. This applies stress to the lead wires or the connections between the lead wires and the conductive layer (e.g., connections made by solder). This stress reduces the strength of the lead wires or the connections, which may cause breakage of the lead wires or the connections.

In particular, when the power generation module is installed outdoors, the sealing member repeatedly contracts and expands with the daily temperature fluctuations. In this case, the lead wires or connections are repeatedly subjected to the above stress, further increasing the risk of breakage.

Thus, the inventors conducted extensive research to find a way to suppress breakage of the lead wires used to extract power, and discovered a configuration in which the lead wires are pre-loosened between the connections and the sealing member. This configuration reduces the stress applied to the lead wires and the connections when the sealing member contracts or expands. Based on this novel finding, the inventors have come up with the following disclosure.

Hereinafter, embodiments of the present disclosure will be described with reference to the drawings. In the following description, terms indicating specific directions or positions (e.g., terms including " up, " " down, " " right, " and " left ") will be used as necessary. However, the use of these terms is intended to facilitate understanding of the present disclosure with reference to the drawings, and the meanings of these terms do not limit the technical scope of the present disclosure or the manner of use of the power generation module according to the present disclosure. Furthermore, the following description is merely exemplary in nature and is not intended to limit the present disclosure, its applications, or its uses. In addition, the drawings are schematic, and the proportions of the dimensions do not necessarily match the actual ones.

In this specification, "electrically connected" means at least one of the following: current can be conducted between plural components; plural components are capacitively coupled; and plural components are electromagnetically coupled.

### (First Embodiment)

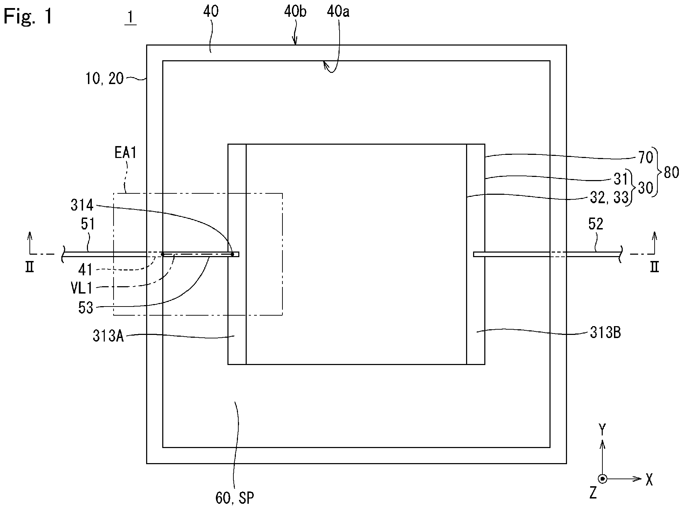

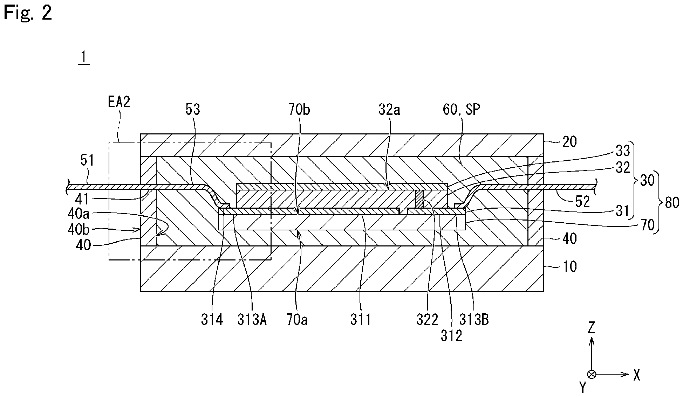

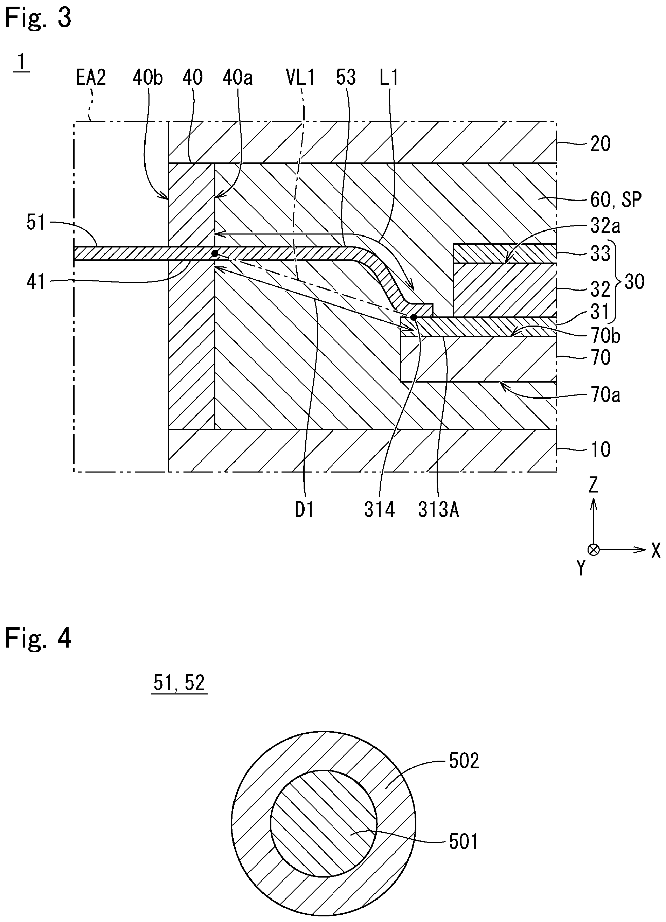

Referring to Figs. 1 to 3, a power generation module according to a first embodiment of the present disclosure will be described. Fig. 1 is a plan view of the power generation module according to the first embodiment of the present disclosure. Fig. 2 is a cross-sectional view taken along line II-II in Fig. 1. Fig. 3 is an enlarged cross-sectional view showing an area EA2 in Fig. 2. For convenience of explanation, an X-Y-Z Cartesian coordinate system is shown in the drawings, but this coordinate system is intended to facilitate understanding of the present disclosure and does not limit the present disclosure.

A power generation module 1 is a module used in building integrated photovoltaics (BIPV). The power generation module 1 also functions as a building material such as a roof, a wall, or a window. The building material constitutes at least a part of, for example, a building or a vehicle. In this embodiment and second to fourth embodiments described below, an example will be described in which the power generation module 1 is integrated with a window.

### [1. Configuration of Power Generation Module]

As shown in Figs. 1 and 2, the power generation module 1 includes a first substrate 10 and a second substrate 20 that faces the first substrate 10 in the thickness direction of the first substrate 10. In the following description, the thickness direction of the first substrate 10 will be simply referred to as the "thickness direction" or the Z direction. Furthermore, one of the directions that intersect with the thickness direction will be referred to as the X direction, and the direction that intersects with both the X direction and the Z direction will be referred to as the Y direction. In the Z direction, the direction from the first substrate 10 toward the second substrate 20 will be referred to as the upward direction, and the direction from the second substrate 20 toward the first substrate 10 will be referred to as the downward direction.

As shown in Fig. 2, one submodule 80 is disposed between the first substrate 10 and the second substrate 20. The submodule 80 has a plate-shaped base member 70 and a solar cell 30 disposed on the base member 70. In other words, the solar cell 30 is located between the first substrate 10 and the second substrate 20.

In a gap between the first substrate 10 and the second substrate 20, a sealing member 40 that seals the gap is disposed. As shown in Fig. 1, the sealing member 40 has an annular shape that surrounds the solar cell 30 in plan view seen from the Z direction. As shown in Figs. 1 and 2, two lead wires 51 and 52 that extract power generated in the solar cell 30 to the outside of the power generation module 1 are connected to the solar cell 30. As shown in Fig. 2, each of the lead wires 51 and 52 passes through the sealing member 40 and extends to the outside of the power generation module 1.

The first substrate 10, the second substrate 20, and the sealing member 40 define an internal space SP of the power generation module 1. The internal space SP houses the submodule 80. The internal space SP may be hollow, for example. In this case, the internal space SP may be filled with a gas such as air, nitrogen, or argon. In this embodiment, the internal space SP is filled with a filler 60, which will be described later.

The first substrate 10 and the second substrate 20 are base materials that form the outer periphery of the power generation module 1. In this embodiment, the first substrate 10 and the second substrate 20 are rectangular in shape with sides extending in the X direction and the Y direction, respectively, in plan view (see Fig. 1), and have the same or substantially the same dimensions.

The first substrate 10 and the second substrate 20 are made of a material with low moisture and gas permeability so as to suppress intrusion of moisture and gas into the internal space SP from the outside of the power generation module 1. For example, the first substrate 10 and the second substrate 20 are made of a material such as resin or glass.

Furthermore, the second substrate 20 has a light-transmitting property so that light can be incident on the solar cell 30 from outside the power generation module 1. In this embodiment, the first substrate 10 and the second substrate 20 are transparent glass plates.

As shown in Fig. 2, the base member 70 is located apart from both the first substrate 10 and the second substrate 20. In this embodiment, the base member 70 is rectangular in shape with sides extending in the X direction and the Y direction in plan view (see Fig. 1), and is smaller than the first substrate 10 and the second substrate 20. The base member 70 is located in the center of the power generation module 1 in plan view.

As shown in Fig. 2, the base member 70 has a lower surface 70a that faces the first substrate 10 through the filler material 60, and an upper surface 70b opposite the lower surface 70a. In this embodiment, the solar cell 30 is disposed on the upper surface 70b. For example, the base member 70 is made of a material such as resin or glass. In this embodiment, the base member 70 is a transparent glass plate.

As shown in Fig. 3, the solar cell 30 has a first electrode layer 31 disposed directly on the upper surface 70b of the base member 70, a semiconductor layer 32 stacked above the first electrode layer 31, and a second electrode layer 33 stacked above the semiconductor layer 32. In other words, the solar cell 30 has a stacked structure in which the semiconductor layer 32 is stacked between the first electrode layer 31 and the second electrode layer 33 in the Z direction.

As shown in Fig. 2, the first electrode layer 31 is disposed directly on the base member 70 and is located below the semiconductor layer 32. In this embodiment, the first electrode layer 31 is disposed over the entire upper surface 70b of the base member 70. The first electrode layer 31 is separated into a first portion 311 and a second portion 312 in the X direction. The portion between the first portion 311 and the second portion 312 is configured as part of the semiconductor layer 32.

The first portion 311 of the first electrode layer 31 and the second electrode layer 33 each function as a positive electrode or a negative electrode in the solar cell 30. The second portion 312 is connected to the second electrode layer 33 by a conductive member 322 that extends through the semiconductor layer 32. In other words, the second portion 312 is electrically connected to the second electrode layer 33.

For example, the first electrode layer 31 may be an electrode made of a metal such as silver, aluminum, copper, or molybdenum, or an alloy thereof, or a transparent electrode made of fluorine-doped tin oxide (FTO), indium oxide (ITO), indium zinc oxide (IZO), tin oxide, zinc oxide, aluminum zinc oxide (AZO), or the like. In this embodiment, the first electrode layer 31 is a transparent electrode made of fluorine-doped tin oxide. For example, the first electrode layer 31 may be formed by a known method such as vapor deposition, sputtering, or inkjet printing.

The semiconductor layer 32 has a function of converting light energy into electrical energy. For example, the semiconductor layer 32 is made of single crystal silicon, polycrystalline silicon, amorphous silicon, microcrystalline silicon, a compound semiconductor, or an organic semiconductor. In this embodiment, the semiconductor layer 32 is made of perovskite crystal and has a layered structure in which a p-type semiconductor, an intrinsic semiconductor, and an n-type semiconductor are stacked. Furthermore, the semiconductor layer 32 may further include layers for protecting these semiconductors or for transporting charges or holes. For example, the semiconductor layer 32 may be formed by a known method such as spin coating or inkjet printing.

As shown in Fig. 1, the dimension of the semiconductor layer 32 in the Y direction is, for example, the same as or substantially the same as the dimension of the base member 70 in the Y direction. On the other hand, the dimension of the semiconductor layer 32 in the X direction is smaller than the dimensions of the base member 70 and the first electrode layer 31 in the X direction.

As shown in Fig. 2, the second electrode layer 33 is located above the semiconductor layer 32. In this embodiment, the second electrode layer 33 is disposed on the entire upper surface 32a of the semiconductor layer 32. The second electrode layer 33 has a light-transmitting property so that light incident on the power generation module 1 along the Z direction can reach the semiconductor layer 32. For example, the second electrode layer 33 is a transparent electrode made of the above material. In this embodiment, the second electrode layer 33 is a transparent electrode made of indium oxide. The second electrode layer 33 can be formed by a known method such as vapor deposition, sputtering, or inkjet printing.

As shown in Fig. 1, the first electrode layer 31 has extensions 313A and 313B that protrude in the X direction from the semiconductor layer 32 in plan view. In this embodiment, the two extensions 313A and 313B are disposed on both sides of the semiconductor layer 32 in the X direction. The extension 313A on one hand is part of the first portion 311, and the extension 313B on the other is part of the second portion 312.

The sealing member 40 suppresses intrusion of moisture and gas into the internal space SP from outside the power generation module 1. In this embodiment, the sealing member 40 is disposed along the edges of each of the first substrate 10 and the second substrate 20 in plan view. The sealing member 40 has an inner surface 40a that faces the solar cell 30 in a direction intersecting the Z direction (XY direction), and an outer surface 40b on the opposite side. For example, the sealing member 40 is made of a material such as rubber or resin. In this embodiment, the sealing member 40 is made of butyl rubber.

For example, the sealing member 40 may be placed on the first substrate 10 before the second substrate 20 is stacked on top of the submodule 80, or may be placed in the gap between the first substrate 10 and the second substrate 20 after the second substrate 20 is stacked on top of the submodule 80.

As shown in Fig. 2, the filler 60 fills the internal space SP so as to fill the entire space excluding the submodule 80 and the lead wires 51 and 52, thereby sealing the portions of the submodule 80 and the lead wires 51 and 52 located in the internal space SP. For example, the filler 60 is made of a material such as an organic compound, an inorganic compound, or a resin. The filler 60 may also contain a moisture absorbent, an oxygen scavenger, or the like. In this embodiment, the filler 60 is made of polyolefin (PO) and is transparent. This allows light to enter the solar cell 30, even though the filler 60 is disposed between the second substrate 20 and the solar cell 30 in the Z direction.

In one example of a manufacturing process for the power generation module 1, the filler 60 is formed into a sheet shape in advance and placed between the first substrate 10 and the submodule 80, and between the submodule 80 and the second substrate 20. The power generation module 1 is then heated, and the first substrate 10 and the second substrate 20 are pressed in the Z direction. At this time, the two sheet-shaped filler materials 60 melt due to the heat and flow into the sides of the submodule 80. As a result, the internal space SP is filled with the filler 60.

Each of the lead wires 51 and 52 passes through the sealing member 40 and extends to the outside of the power generation module 1. For example, each of the lead wires 51 and 52 is connected, outside the power generation module 1, to a controller (not shown) that controls power generation and distributes the generated power, or to a terminal disposed on a terminal box.

Each of the lead wires 51 and 52 is connected to the first electrode layer 31 or the second electrode layer 33 of the solar cell 30 in the internal space SP of the power generation module 1. The connection between the lead wires 51 and 52 and the first electrode layer 31 or the second electrode layer 33 is made by, for example, soldering or applying a metal paste. In this embodiment, the lead wire 51 is connected to the first portion 311 of the first electrode layer 31, and the lead wire 52 is connected to the second portion 312 of the first electrode layer 31. Therefore, the lead wire 52 is electrically connected to the second electrode layer 33 via the second portion 312 and the conductive member 322. Each of the lead wires 51 and 52 is connected to the positive electrode or the negative electrode of the solar cell 30.

As shown in Fig. 3, the lead wire 51 is connected to the extension 313A that is part of the first portion 311. The first electrode layer 31 has a connection 314 in the extension 313A to which the lead wire 51 is connected. In addition, the lead wire 52 is connected to the extension 313B that is part of the second portion 312.

For example, the lead wires 51 and 52 may be connected to the first electrode layer 31 during the process of fabricating the solar cell 30, or may be connected to the first electrode layer 31 during the process of placing the solar cell 30 in the internal space SP. Furthermore, the formation of an internal wiring portion 53, which will be described later, may be performed before or after connecting the lead wires 51 and 52 to the first electrode layer 31.

Fig. 4 is a cross-sectional view of a lead wire disposed in the power generation module of Fig. 1. Each of the lead wires 51 and 52 is electrically conductive. In this embodiment, as shown in Fig. 4, each of the lead wires 51 and 52 includes a copper wire 501 and a solder layer 502 that covers the copper wire 501. The solder layer 502 constitutes the outermost layer of each of the lead wires 51 and 52. The solder layer 502 suppresses the occurrence of rust in the copper wire 501. Furthermore, when each of the lead wires 51 and 52 is solder-connected to the first electrode layer 31 or the second electrode layer 33, the solder layer 502 functions as a pre-solder.

As shown in Fig. 3, the sealing member 40 has a pass-through portion 41 through which the lead wire 51 passes. For example, the pass-through portion 41 includes an intersection between the inner surface 40a and the lead wire 51. In this embodiment, the pass-through portion 41 is located in the center of the sealing member 40 in the Z direction. Specifically, the position of the pass-through portion 41 in the Z direction is higher than the position of the connection 314 in the Z direction. Furthermore, as shown in Fig. 1, the position of the pass-through portion 41 in the Y direction coincides with the position of the connection 314 in the Y direction.

The lead wire 51 is fixed to the sealing member 40 at the pass-through portion 41. In this embodiment, the lead wire 51 is arranged so as to be embedded in the uncured sealing member 40 during the manufacturing process of the power generation module 1. The sealing member 40 is then subjected to a curing process. Therefore, the sealing member 40 is directly bonded to the portion of the lead wire 51 that penetrates the sealing member 40.

As shown in Fig. 3, the lead wire 51 has the internal wiring portion 53 which is a portion between the connection 314 and the pass-through portion 41. For example, the internal wiring portion 53 is a portion between the connection 314 and the intersection of the inner surface 40a and the lead wire 51.

A length L1 of the internal wiring portion 53 is greater than a shortest distance D1 between the connection 314 and the pass-through portion 41. This allows the internal wiring portion 53 to be in a loosened state in the internal space SP. Here, unless otherwise specified, the length of the internal wiring portion 53 refers to the length of the internal wiring portion 53 when it is assumed that the internal wiring portion 53 is extended in a straight line. In other words, the shortest distance is the length of a virtual line VL1 joining the connection 314 and the pass-through portion 41 in the three-dimensional space. For example, the length L1 of the internal wiring portion 53 may be greater than the shortest distance between the connection 314 and the intersection of the connection 314 and the lead wire 51 on the inner surface 40a.

In the first embodiment, the internal wiring portion 53 has a linear shape joining the connection 314 and the pass-through portion 41 in plan view (see Fig. 1). On the other hand, as shown in Fig. 3, the internal wiring portion 53 has a shape that curves upward with respect to the virtual line VL1 joining the connection 314 and the pass-through portion 41. This makes it possible to implement the internal wiring portion 53 that has a linear shape in plan view and is greater than the shortest distance D1 between the connection 314 and the pass-through portion 41. In other words, it is possible to achieve both an inconspicuous appearance of the internal wiring portion 53 and suppression of breakage of the internal wiring portion 53.

### [2. Effects, etc.]

According to the power generation module 1 described above, the length L1 of the internal wiring portion 53 is greater than the shortest distance D1 between the connection 314 and the pass-through portion 41, so that the internal wiring portion 53 can be in a loosened state when the sealing member 40 is not contracted. This makes it difficult for the internal wiring portion 53 to become taut when the sealing member 40 contracts, thereby reducing the stress applied to the lead wire 51 and the connection 314. This makes it possible to suppress breakage of the lead wire 51 for extracting electric power.

In the manufacturing process of the power generation module 1, the first substrate 10 and the second substrate 20 are bonded together, for example, by being pressed in the Z direction while being heated. At this time, the filler 60 disposed above and below the solar cell 30 flows in the Z direction toward the spaces to the sides of the solar cell 30. This flow of the filler 60 may deform the internal wiring portion 53, which has been formed into a desired shape in advance, in the Z direction.

According to the power generation module 1 described above, the internal wiring portion 53 is loose in the Z direction, and therefore stress induced by an external force acting in the Z direction on the internal wiring portion 53 can be reduced compared to a configuration in which the internal wiring portion 53 is not loose in the Z direction. Thus, breakage of the lead wires 51 for extracting electric power can be further suppressed.

According to the power generation module 1 described above, the apparent length of the internal wiring portion 53 as viewed from the Z direction is shorter than the apparent length of an internal wiring portion having a shape other than a straight shape in plan view, i.e., an internal wiring portion having a shape that is curved in a direction intersecting the Z direction. This makes the internal wiring portion 53 less noticeable when the power generation module 1 is viewed from the Z direction. This makes it possible to implement the power generation module 1 that suppresses breakage of the lead wires 51 and that has an excellent appearance.

### (Second Embodiment)

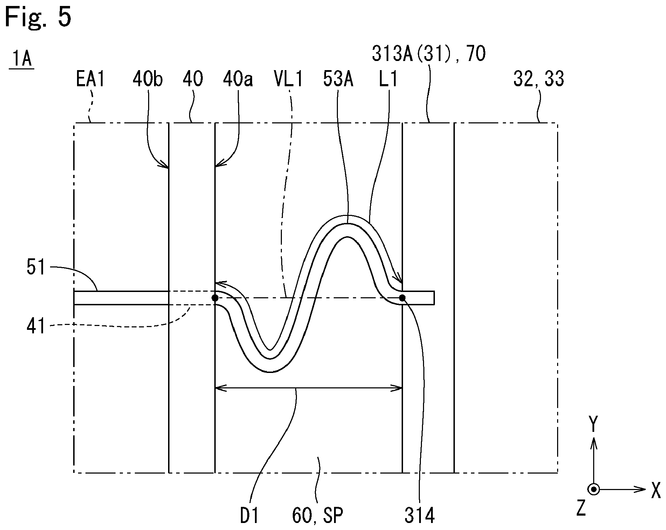

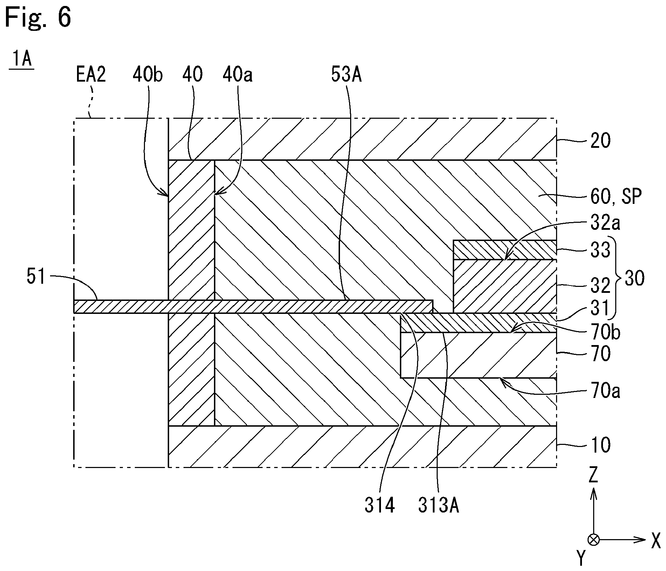

A power generation module 1A according to a second embodiment of the present disclosure will be described with reference to Figs. 5 and 6. Fig. 5 is a diagram showing the power generation module according to the second embodiment of the present disclosure, and is an enlarged plan view corresponding to an area EA1 in Fig. 1. Fig. 6 is a diagram showing the power generation module according to the second embodiment of the present disclosure, and is an enlarged cross-sectional view corresponding to the area EA2 in Fig. 2.

The power generation module 1A according to the second embodiment differs from the power generation module 1 according to the first embodiment in the shape of an internal wiring portion 53A. In the following description of the second embodiment, the same components as those in the power generation module 1 will be given the same reference numerals and the description thereof may be omitted.

As shown in Fig. 6, the internal wiring portion 53A has a linear shape when viewed in a direction intersecting the Z direction (the Y direction in this embodiment). On the other hand, as shown in Fig. 5, the internal wiring portion 53A has a shape that is curved in a direction intersecting the Z direction with respect to the virtual line VL1 joining the connection 314 and the pass-through portion 41. In this embodiment, the internal wiring portion 53A has a serpentine shape in the Y direction. That is, the internal wiring portion 53A has a shape that is curved on both sides of the virtual line VL1 in plan view. As a result, the length L1 of the internal wiring portion 53A is greater than the shortest distance D1 between the connection 314 and the pass-through portion 41.

During the manufacturing process of the power generation module 1A, the filler 60 placed above and below the solar cell 30 may flow to the side of the solar cell 30, causing the pre-formed internal wiring portion 53 to deform in the Z direction.

According to the power generation module 1A described above, the internal wiring portion 53 has a shape that is curved in a direction intersecting the Z direction, and hence, compared to a configuration in which the internal wiring portion 53 has a shape that is curved only in the Z direction, the shape of the internal wiring portion 53 is easily maintained even after the first substrate 10 and the second substrate 20 are bonded together. Thus, the power generation module 1A in which the shape of the internal wiring portion 53 is stable can be implemented.

### (Third Embodiment)

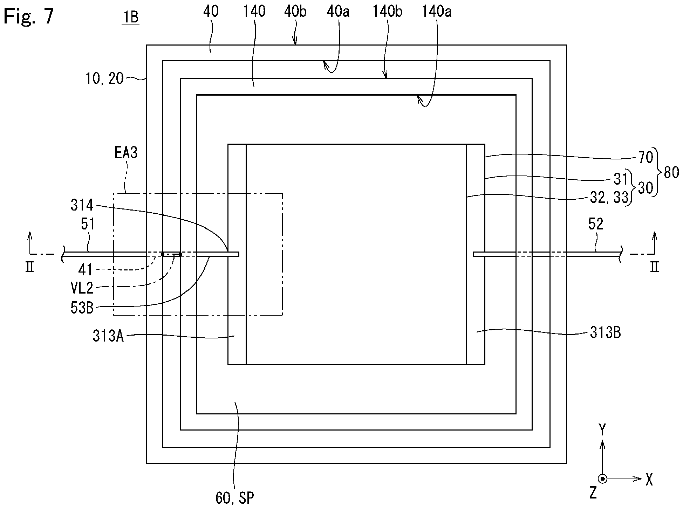

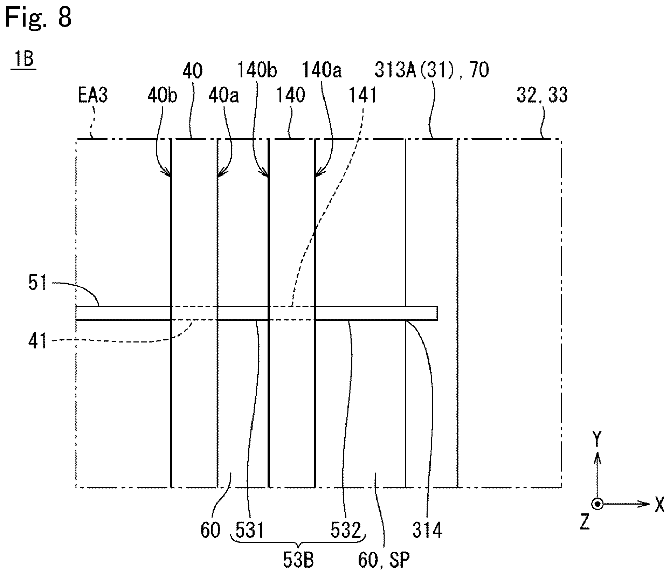

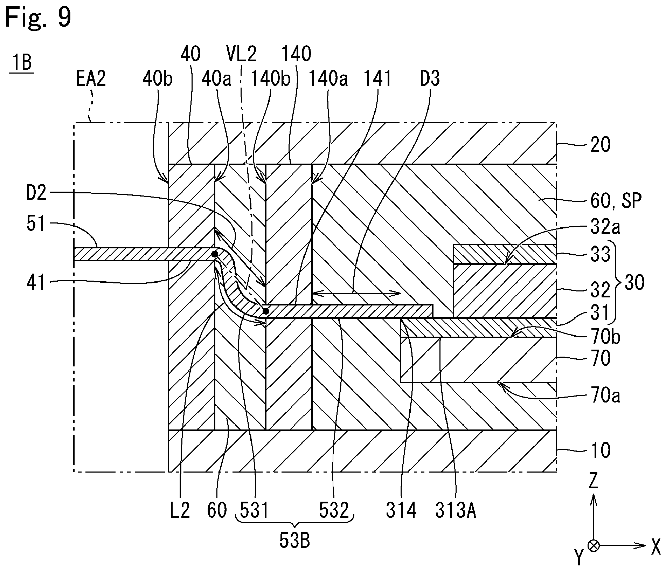

A power generation module 1B according to a third embodiment of the present disclosure will be described with reference to Figs. 7 to 9. Fig. 7 is a plan view of the power generation module according to the third embodiment of the present disclosure. Fig. 8 is an enlarged plan view corresponding to an area EA3 in Fig. 7. Fig. 9 is a diagram showing the power generation module according to the third embodiment of the present disclosure, and is an enlarged cross-sectional view corresponding to the area EA2 in Fig. 2.

The power generation module 1B according to the third embodiment differs from the power generation module 1 according to the first embodiment in that it further includes an internal sealing member 140. In the following description of the third embodiment, the same components as those in the power generation module 1 will be given the same reference numerals and their description may be omitted. The sealing member 40 may also be referred to as an "external sealing member."

Similar to the sealing member 40, the internal sealing member 140 is disposed in the gap between the first substrate 10 and the second substrate 20 to seal the gap. As shown in Fig. 7, the internal sealing member 140 is disposed inward of the sealing member 40 in plan view, and has an annular shape that surrounds the solar cell 30. In plan view, the solar cell 30 is surrounded by a double seal of the sealing member 40 and the internal sealing member 140.

The further provision of the internal sealing member 140 improves the sealing performance between the outside of the power generation module 1B and the internal space SP, thereby suppressing intrusion of moisture and gas that may deteriorate the solar cell 30 into the internal space SP, to consequently extend the life of the solar cell 30.

As shown in Fig. 9, the internal space SP in the power generation module 1B is defined by the first substrate 10, the second substrate 20, and the internal sealing member 140.

The internal sealing member 140 has an inner surface 140a that faces the solar cell 30 in a direction intersecting the Z direction, and an outer surface 140b on the opposite side.

The oxygen permeability of the internal sealing member 140 is lower than that of the sealing member 40. Here, the oxygen permeability refers to the gas permeability measured using oxygen as a test gas by a method specified in, for example, JIS K6275-1, JIS K6275-2, JIS K7126-1, or JIS K7126-2. In this embodiment, the sealing member 40 is made of butyl rubber, and the internal sealing member 140 is made of ethylene-vinyl alcohol copolymer resin (EVOH). Hence, the linear expansion coefficient of the material of the sealing member 40 is different from the linear expansion coefficient of the material of the internal sealing member 140.

As shown in Fig. 9, the lead wire 51 passes through not only the sealing member 40 but also the internal sealing member 140 and extends to the outside of the power generation module 1B. The internal sealing member 140 has an internal pass-through portion 141 through which the lead wire 51 passes. For example, the internal pass-through portion 141 includes an intersection between the inner surface 140a and the lead wire 51 and an intersection between the outer surface 140b and the lead wire 51. The lead wire 51 is fixed to the internal sealing member 140 at the internal pass-through portion 141.

An internal wiring portion 53B has a first wiring portion 531 that is the portion between the pass-through portion 41 and the internal pass-through portion 141, and a second wiring portion 532 that is the portion between the internal pass-through portion 141 and the connection 314. For example, the first wiring portion 531 is the portion between the intersection of the inner surface 40a of the sealing member 40 and the lead wire 51 and the intersection of the outer surface 140b of the internal sealing member 140 and the lead wire 51. Furthermore, for example, the second wiring portion 532 is the portion between the intersection of the inner surface 140a of the internal sealing member 140 and the lead wire 51 and the connection 314.

As shown in Fig. 8, the internal wiring portion 53B has a rectilinear shape joining the connection 314 and the pass-through portion 41 in plan view. As shown in Fig. 9, the first wiring portion 531 has a shape that curves downward with respect to a virtual line VL2 joining the pass-through portion 41 and the internal pass-through portion 141. As a result, a length L2 of the first wiring portion 531 is greater than the shortest distance D2 between the pass-through portion 41 and the internal pass-through portion 141. In this embodiment, the shortest distance D2 between the pass-through portion 41 and the internal pass-through portion 141 is shorter than the shortest distance D3 between the internal pass-through portion 141 and the connection 314.

According to the power generation module 1B described above, the internal space SP is doubly sealed by the sealing member 40 and the internal sealing member 140. This makes it possible to further suppress the intrusion of moisture and gas into the internal space SP compared to the power generation module 1 having only the sealing member 40.

According to the power generation module 1B described above, the internal sealing member 140 having a lower oxygen permeability than the sealing member 40 is disposed, and therefore the amount of oxygen that intrudes into the internal space SP can be reduced compared to a power generation module 1 that does not have the internal sealing member 140. Therefore, deterioration of the solar cell 30 due to oxygen can be further suppressed.

When the temperature of the environment in which the power generation module 1B is installed drops, both the sealing member 40 and the internal sealing member 140 contract. At this time, the first wiring portion 531 of the internal wiring portion 53B, both ends of which are fixed to the sealing member 40 and the internal sealing member 140, is pulled in two opposite directions. Therefore, the first wiring portion 531 has a higher risk of breaking the internal wiring portion 53B than the second wiring portion 532, which is pulled only by the internal sealing member 140.

According to the power generation module 1B described above, the first wiring portion 531, which is at a higher risk of breaking, can be loosened in the internal wiring portion 53B. Thus, in a configuration in which both the sealing member 40 and the internal sealing member 140 are disposed, breakage of the internal wiring portion 53B can be further suppressed.

### (Fourth Embodiment)

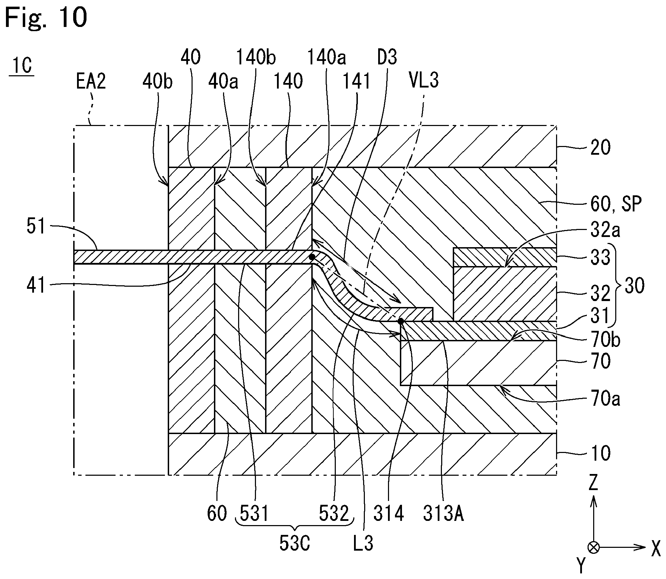

Referring to Fig. 10, a power generation module 1C according to a fourth embodiment of the present disclosure will be described. Fig. 10 is a diagram showing the power generation module according to the fourth embodiment of the present disclosure, and is an enlarged cross-sectional view corresponding to the area EA2 in Fig. 2.

The power generation module 1C according to the fourth embodiment differs from the power generation module 1B according to the third embodiment in the shape of the internal wiring portion 53C. As shown in Fig. 10, the second wiring portion 532 has a shape that curves downward with respect to a virtual line VL3 that joins the internal pass-through portion 141 and the connection 314. As a result, a length L3 of the second wiring portion 532 is greater than the shortest distance D3 between the internal pass-through portion 141 and the connection 314.

The connection 314 between the lead wire 51 and the first electrode layer 31 has a mechanical strength weaker than that of the lead wire 51 itself. According to the power generation module 1C described above, the second wiring portion 532, one end of which is fixed to the connection 314, can be loosened, and hence breakage at the connection 314 can be suppressed compared to a configuration in which the second wiring portion 532 is not loosened.

The present disclosure is not limited to the above embodiment and can be embodied in various other forms. For example, the power generation module 1 may include a plurality of solar cells 30. The plurality of solar cells 30 may be connected to each other by wiring disposed in the internal space SP.

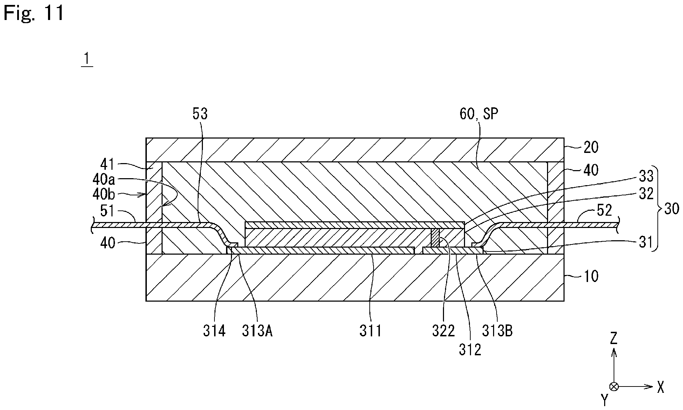

Furthermore, although the solar cell 30 is described above as being disposed on the base member 70, the present disclosure is not limited thereto. For example, as in a variant shown in Fig. 11, the solar cell 30 may be disposed directly on the first substrate 10. That is, the first electrode layer 31 may be in contact with the first substrate 10. In this case, the base member 70 may not be disposed.

The number of lead wires 51 and 52 disposed in the power generation module 1 may be three or more depending on the number of solar cells 30 and the like.

The internal space SP may be hollow and not filled with the filler 60. In this case, the internal space SP may be filled with a gas such as air, nitrogen, or argon.

Furthermore, although the first substrate 10, the second substrate 20, the first electrode layer 31, the second electrode layer 33, the filler 60, and the base member 70 are described above as being transparent, the present disclosure is not limited thereto. The second substrate 20, the second electrode layer 33, and the filler 60 may be configured as opaque or colored members as long as they have a light-transmitting property so as to allow light necessary for power generation to enter the semiconductor layer 32. Furthermore, if the power generation module 1 is used as a building material other than a window, the first substrate 10, the second electrode layer 33, and the base member 70 need not be transparent.

Although the lead wire 51 is connected to the extension 313A in the above description, the present disclosure is not limited thereto. For example, the lead wire 51 may be connected to a portion of the first portion 311 excluding the extension 313A. Alternatively, the lead wire 51 may be connected to the second electrode layer 33, and the lead wire 52 may be connected to the first portion 311 of the first electrode layer 31.

Each of the internal wiring portion 53, the first wiring portion 531, and the second wiring portion 532 may have a shape curved in both the Y direction and the Z direction. The first wiring portion 531 of the internal wiring portion 53 may have a shape curved with respect to the virtual line VL2, and the second wiring portion 532 may have a shape curved with respect to the virtual line VL3.

The material of the internal sealing member 140 may be the same as the material of the sealing member 40. The oxygen permeability of the internal sealing member 140 may be the same as or higher than the oxygen permeability of the sealing member 40. The material of the internal sealing member 140 is not limited to ethylene-vinyl alcohol copolymer resin, and may be, for example, polyvinylidene fluoride, polyamide-based resin, or the like.

Furthermore, although the submodule 80 is described above as being oriented such that the solar cells 50 are located above the base member 70, the present disclosure is not limited thereto. For example, the submodule 80 may be oriented upside down relative to the orientation in the first to fourth embodiments described above. That is, the first electrode layer 31 may be disposed directly on the lower surface 70a of the base member 70, and the semiconductor layer 32 and the second electrode layer 33 may be stacked below the base member 70.

In this case, for example, if the base member 70 and the first electrode layer 31 are configured to have a light-transmitting property, light that enters the internal space SP through the second substrate 20 can reach the semiconductor layer 32 through the base member 70 and the first electrode layer 31. In this case, the second electrode layer 33 located below the semiconductor layer 32 need not be light-transmissive.

The pass-through portion 41 or the internal pass-through portion 141 may be located below the connection 314 in the Z direction.

In the first embodiment, the internal wiring portion 53 has a shape curved upward with respect to the virtual line VL1, but may have a shape curved downward with respect to the virtual line VL1. In the third embodiment, the first wiring portion 531 has a shape curved downward with respect to the virtual line VL2, but may have a shape curved upward with respect to the virtual line VL2. In the fourth embodiment, the second wiring portion 532 has a shape curved downward with respect to the virtual line VL3, but may have a shape curved upward with respect to the virtual line VL3.

In the second embodiment, the internal wiring portion 53Ahas a shape curved on both sides of the virtual line VL1 in plan view, but may have a shape curved on only one side of the virtual line VL1 in plan view.

Any of the various embodiments or variants described above can be combined appropriately to achieve their respective effects. In addition, combinations of embodiments, combinations of examples, or combinations of embodiments and examples are possible, and combinations of features from different embodiments or examples are also possible.

Although the present disclosure has been fully described in connection with the preferred embodiments with reference to the accompanying drawings, various changes and modifications will be apparent to those skilled in the art, and such changes and modifications are to be understood as being encompassed within the scope of the present disclosure as defined by the appended claims unless they depart therefrom.

### (Summary of Embodiments)

(1) A power generation module of the present disclosure includes: a first substrate; a second substrate having a light-transmitting property, the second substrate facing the first substrate in a thickness direction of the first substrate; a solar cell located between the first substrate and the second substrate; a sealing member sealing a gap between the first substrate and the second substrate, the sealing member having an annular shape surrounding the solar cell in a plan view seen along the thickness direction; and a lead wire connected to the solar cell and passing through the sealing member. The solar cell has a stacked structure, two electrode layers and a semiconductor layer being located between the two electrode layers in the thickness direction are stacked in the stacked structure. One of the two electrode layers has a connection connected to the lead wire. The sealing member has a pass-through portion, the lead wire passing through and being fixed to the pass-through portion. The lead wire has an internal wiring portion between the connection and the pass-through portion. A length of the internal wiring portion is greater than the shortest distance between the connection and the pass-through portion.
(2) In the power generation module of (1), the internal wiring portion has a shape curving in the thickness direction with respect to a virtual line joining the connection and the pass-through portion.
(3) In the power generation module of (2), the internal wiring portion has a rectilinear shape joining the connection and the pass-through portion in the plan view.
(4) In the power generation module of (1) or (2), the internal wiring portion has a shape curving in a direction intersecting with the thickness direction with respect to a virtual line joining the connection and the pass-through portion.
(5) In the power generation module of any one of (1) to (4), it further includes: an internal sealing member sealing a gap between the first substrate and the second substrate, the internal sealing member being positioned inward of the sealing member in the plan view and having an annular shape surrounding the solar cell. The internal sealing member has an internal pass-through portion, the lead wire passing through and being fixed to the pass-through portion.
(6) In the power generation module of (5), a length of the internal wiring portion between the pass-through portion and the internal pass-through portion is greater than the shortest distance between the pass-through portion and the internal pass-through portion.
(7) In the power generation module of (5) or (6), a length of the internal wiring portion between the connection and the internal pass-through portion is greater than the shortest distance between the connection and the internal pass-through portion.
(8) In the power generation module of any one of (5) to (7), an oxygen permeability of the internal sealing member is lower than an oxygen permeability of the sealing member.

### INDUSTRIAL APPLICABILITY

The present disclosure is applicable to power generation modules used in building integrated photovoltaics.

### REFERENCE SIGNS LIST

- 1, 1A to 1C: power generation module
- 10: first substrate
- 20: second substrate
- 30: solar cell
- 31: first electrode layer
- 314: connection
- 32: semiconductor layer
- 33: second electrode layer
- 40: sealing member
- 41: pass-through portion
- 51, 52: lead wire
- 53, 53A to 53C: internal wiring portion
- 140: internal sealing member
- 141: internal pass-through portion

## Claims

1. A power generation module comprising:
a first substrate;
a second substrate having a light-transmitting property, the second substrate facing the first substrate in a thickness direction of the first substrate;
a solar cell located between the first substrate and the second substrate;
a sealing member sealing a gap between the first substrate and the second substrate, the sealing member having an annular shape surrounding the solar cell in a plan view seen along the thickness direction; and
a lead wire connected to the solar cell and passing through the sealing member, wherein:
the solar cell has a stacked structure, two electrode layers and a semiconductor layer being located between the two electrode layers in the thickness direction are stacked in the stacked structure;
one of the two electrode layers has a connection connected to the lead wire;
the sealing member has a pass-through portion, the lead wire passing through and being fixed to the pass-through portion;
the lead wire has an internal wiring portion between the connection and the pass-through portion; and
a length of the internal wiring portion is greater than the shortest distance between the connection and the pass-through portion.

2. The power generation module according to claim 1, wherein
the internal wiring portion has a shape curving in the thickness direction with respect to a virtual line joining the connection and the pass-through portion.

3. The power generation module according to claim 2, wherein
the internal wiring portion has a rectilinear shape joining the connection and the pass-through portion in the plan view.

4. The power generation module according to claim 1, wherein
the internal wiring portion has a shape curving in a direction intersecting with the thickness direction with respect to a virtual line joining the connection and the pass-through portion.

5. The power generation module according to claim 1, further comprising:
an internal sealing member sealing a gap between the first substrate and the second substrate, the internal sealing member being positioned inward of the sealing member in the plan view and having an annular shape surrounding the solar cell, wherein:
the internal sealing member has an internal pass-through portion, the lead wire passing through and being fixed to the pass-through portion.

6. The power generation module according to claim 5, wherein
a length of the internal wiring portion between the pass-through portion and the internal pass-through portion is greater than the shortest distance between the pass-through portion and the internal pass-through portion.

7. The power generation module according to claim 5, wherein
a length of the internal wiring portion between the connection and the internal pass-through portion is greater than the shortest distance between the connection and the internal pass-through portion.

8. The power generation module according to claim 5, wherein
an oxygen permeability of the internal sealing member is lower than an oxygen permeability of the sealing member.
